# EUROPEAN PATENT APPLICATION

(11) **EP 3 171 164 A1**
(43) Date of publication of application: **24.05.2017**
(21) Application number: 15290290.4
(22) Date of filing: 20.11.2015
(51) Int. Cl.: G01N 27/04, G01R 31/34

(54) **A TOOL AND A METHOD TO MEASURE A CONTAMINATION IN A SLOT OF A CONDUCTOR BAR**

(71) Applicant: General Electric Technology GmbH, 5400 Baden (CH)
(72) Inventor: Clemence, Laurent Didier Jean, 90400 Danjoutin (FR); Bermond, Stéphane Christian Avit, 90000 Belfort (FR)
(74) Representative: General Electric Technology GmbH

(57) **Abstract**

This invention relates to determining the functional capability of an electric machine by checking the degree of contamination in a slot for housing a conductor bar. It is an object of the invention to appropriately determine the pollution of a slot of an electric machine. Disclosed is a tool to measure a contamination in a slot for a conductor bar of an electric machine, with a voltage generator to apply a voltage at the slot and a voltmeter to measure a voltage drop along the slot, and a processor to calculate the contamination from the voltage drop. Further disclosed is a method to measure a contamination in a slot for a conductor bar of an electric machine with the steps of applying a voltage at the slot, measuring a voltage drop along the slot, and calculating the contamination in the slot on basis of the measured voltage drop.

## Description

### TECHNICAL FIELD

The present disclosure relates to the technical field of maintenance of an electric machine. In particular, the disclosure relates to determining the functional capability of an electric machine by checking the degree of contamination in a slot for housing a conductor bar.

The electric machine is in particular a rotating electric machine such as a synchronous generator to be connected to a gas or steam turbine (turbogenerator) or a synchronous generator to be connected to a hydro turbine (hydro generator) or an asynchronous generator or a synchronous or asynchronous electric motor or also other types of electric machines.

### BACKGROUND

Huge electric machines for high power generation have runtimes of many years. Commonly, these electric machines are maintained and repaired as these measures are more economic than a replacement of the complete machine. One component among others to maintain are the slots in the rotor and stator to house the conductor bars of the electric windings. One deficiency with the slots after years of permanent operation is the pollution of the slots with contaminants or debris. The pollution or contamination impairs the electric properties, the electric contact between the conductor bar and the magnetic core. The insulation of the conductor bars is damaged up to complete dissolving of the insulation. Further, the pollution impairs the precise mechanical positioning of the conductor bar into the slot. These contaminants can strongly adhere to the faces of the slots. Therefore, simply washing and cleaning processes do not provide sufficient cleaning results. Several cleaning methods are proposed in the state of the art, manual scraping, grinding tools, dry ice cleaning, or water jet cleaning. However, the methods of the state of the art have disadvantages, there is the risk of over-cleaning which means a waste of working time, and the risk of damaging the material. This is substantial as the time required to clean these slots in big electric machines to be performed by experts is in the range of several days or even weeks depending on the generator and the chosen method and cleaning equipment. Especially the downtime of the generator is a costly critical factor.

### SUMMARY

It is an object of the invention to appropriately determine the pollution of a slot of an electric machine. This object is solved with the features of a tool and a method according to the independent claims.

Further examples of the invention are described in the dependent claims.

In an example of the invention the measuring tips are arranged between the slot and a pressurizing medium to exert a pressure to the measuring tips. The sensitivity of the measurement is increased by these features making the method and tool more efficient.

In a further example the pressurizing medium of the tool is designed as an inflatable tube. This feature ensures a simply and cheap design of the tool.

In a different example the pressurizing medium is a pressure screw which engages at least one wedge to exert a pressure to the measuring tips in a direction perpendicular to the slot via the at least a wedge. In a further example the pressurizing medium contains at least one inflatable device to adjust the position of the pressurizing medium within the slot by inflation. By this configuration of the tool the measuring tips of the tool are securely and precisely fixed during measurement.

### BRIEF DESCRIPTION OF THE DRAWINGS

Further characteristics and advantages will be more apparent from the description of a preferred but non-exclusive embodiment of the tool and the method, illustrated by way of non-limiting example in the accompanying drawings, in which:
- Fig. 1: shows a schematic perspective cut view of a part of a core with a slot, and a tool with three measuring tips arranged at the slot electrically connected to a voltage generator to apply a voltage, a voltmeter to measure a voltage drop along the conductor bar, and a processor to calculate the contamination of the slot on basis of the measurement;
- Fig. 2: shows a cut side view of a wedge of the tool inserted into a slot of an electric machine to exert a pressure to the measuring tips;
- Fig. 3: shows a cut side view of a wedge inserted into a slot of an electric machine similar to Fig. 2;
- Fig. 4: shows three curves of measurements in a slot with a tool and a method according to an example of the invention with the length of the slot at the horizontal axis and a voltage drop at the vertical axis with different pressures exerted to the measuring tips by a pressurizing medium;
- Fig. 5: shows curves of calculated data on basis of measurements in a slot with a tool and a method according to an example of the invention with the length of the slot at the horizontal axis, the voltage drop and an alpha coefficient at the vertical axis, with a first curve illustrating the voltage drop and a second curve derived from the first curve to conclude a contamination in the slot.

### DETAILED DESCRIPTION OF EXEMPLARY EMBODIMENTS

With reference to the figures, these show examples of the invention, wherein like reference numerals designate identical or corresponding parts throughout the several views.

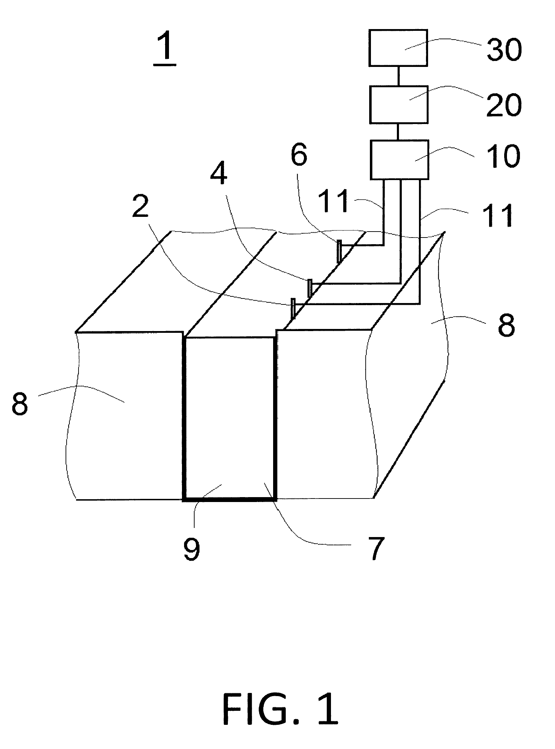

Fig. 1 shows a schematic perspective cut view of a part of a core 8. The core 8 can be a core of a stator or a core of a rotor of an electric machine, especially a turbogenerator. The cut part of the core 8 shows two walls of the core 8 which encompass a slot 7 milled in the core 8 in the middle. The complete core 8 has a cylindrical shape whereas Fig. 1 merely shows a small part without curvature. The slot 7 has a rectangular shape and projects commonly along the whole length of the core 8 in the direction perpendicular to the image plane. A multitude of slots 7 are milled in the core 8 in dependence of the specific electric machine. In Fig. 1 the conductor bar which is regularly placed into the slot 7 in operation is removed. Here, the maintenance is described when the turbogenerator is off. Instead of the conductor bar a pressurizing medium 9 is placed into the slot 7. The pressurizing medium 9 captures the whole space in this example. The pressurizing medium 9 can however only capture a part of the space of the slot 7. The pressurizing medium 9 is an inflatable tube in this example, e.g. a bike tube. The tube is placed in the slot 7 in the uninflated state and is inflated then. In the inflated state the pressurizing medium 9 exerts a pressure against the walls of the core 8 from the inside. Measuring tips 2, 4, 6 are arranged between the walls of the core 8 and the pressurizing medium 9. The pressurizing medium 9 thus exerts a pressure against the measuring tips 2, 4, 6 which pressure resembles the pressure of the conductor bar against the core 8 when inserted. The pressure exerted at the measuring tips 2, 4, 6 can be adjusted between 200mBar and 300mBar for example. Between the outer measuring tip 2 and ground a voltage is applied. The voltage is generated by a voltage generator 10 connected to the outer measuring tips 2, 6 via the signal lines 11. At the measuring tips 2, 4, 6 the voltage is measured by a voltmeter 20. A first voltage or voltage drop is measured between the measuring tip 2 and the measuring tip 4, a second voltage or voltage drop is measured between the measuring tip 4 and the measuring tip 6. With the knowledge of the applied voltage at the outer measuring tip 2 the two voltage drops are measured. The voltage generator 10, voltmeter 20, and/or processor 30 can be integrated in one device in the tool 1. These measured voltage drops between the measuring tips 2, 3, 4 are an indication for a contamination in the slot 7. The values are compared in the processor 30 and from the voltage drop the level of contamination in the slot 7 is diagnosed. The level of contamination provides the maintenance operator with the information whether the slot 7 is sufficiently cleaned or needs further cleaning process. Therefore, the operator obtains important information by this method and tool 1 for the maintenance process.

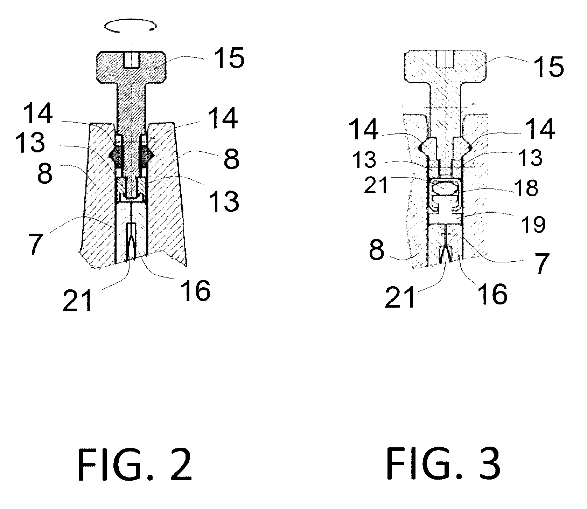

Fig. 2 shows a cut side view of a wedge inserted into a slot 7 of an electric machine as part of the tool 1. The wedge is partitioned in a radial wedge 14 and a pressure wedge 13. The radial wedge 14 and the pressure wedge 13 are engaged by a pressure screw 15 which is screwed perpendicularly into the slot 7. The end of the pressure screw 15 is threaded into the pressure wedge 13. The radial wedge 14 and the pressure wedge 13 exert a pressure to the magnetic core or core 8 in a horizontal direction in the shown perspective. This is an alternative example to the above where the pressure at the measuring tips 2, 3, 4 is exerted by a tube as pressurizing medium 9. The pressurizing medium 9 is hereby replaced by the radial pressure screw 15, the radial wedge 14 and the pressure wedge 13. Below the radial wedge 14 and the pressure wedge 13 a half body 16 is arranged inside the slot 7. In a cavity of the half body 16 an inflatable device 21 is arranged which is used to adjust the position of the half body 16 and the abut pressure wedge 13 in the slot 7. By inflation of the inflatable device 21 in a proper manner the position of the pressure wedge 13 is adjusted in the slot 7 to accommodate the measuring tips 2, 3, 4. The contamination measurement in the slot 7 is done as described with the method and the tool 1.

Fig. 3 shows a cut side view of another wedge inserted into a slot of an electric machine similar to Fig. 2. The wedge has in addition to the wedge described under Fig. 2 additional features. The radial wedge 14 abuts the pressure wedge 13 which surrounds the end of the pressure screw 15. Below the pressure wedge 13 a sliding rule 18 is arranged which abuts below the pressure wedge 13 and clamps a bottom wedge 19 below. The bottom wedge 19 rests against the half body 16. The half body 16 again has a cavity which houses the inflatable device 21. A further feature of this example is a second inflatable device 21 which is positioned between the sliding rule 18 and the bottom wedge 19. Steering the pressure in the first and second inflatable device 21 provides a precise adjustment of the described parts within the slot 7 to put an appropriate pressure to the measuring tips 2, 3, 4 for a secure mechanical and electrical connection of the measuring tips 2, 3, 4 with the slot 7.

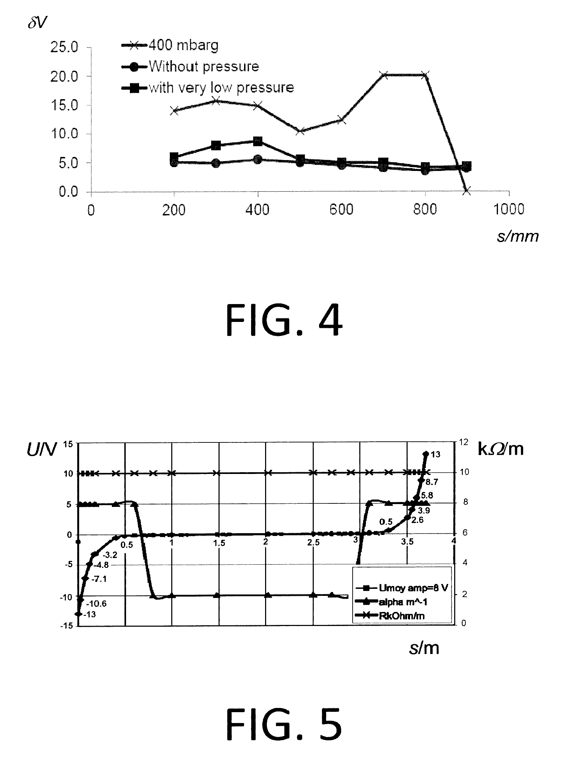

Fig. 4 shows three curves of measurements in a part of the slot 7 by means of a tool 1 and a method according to an example of the invention. The slot 7 is clean without contaminations. The three curves are shown to explain the different measurement results with and without application of pressure by a pressurizing medium 9 to exert a pressure to the measuring tips 2, 4, 6. The length of the slot 7 is plotted at the horizontal axis in mm. The voltage drop or voltage difference *δV* is plotted at the vertical axis in volt. The curve below illustrated with circle measuring points has a fairly constant curve progression. This curve is measured in a slot 7 without application of pressure to the measuring tips 2, 3, 4. The curve above in the middle with rectangular measuring points has a more uneven curve progression which measured voltage is slightly above the measured voltage of the curve without pressure. In some areas between 200mm and 500mm along the length of the slot 7 the curve diverges more from the below curve. The third curve is measured by the voltmeter 20 with an applied pressure of 400mBar to the measuring tips 2, 4, 6. It can be clearly seen from the third curve above with measuring points marked with crosses that the application of pressure to the measuring tips 2, 3, 4 enhances the output in terms of measured voltages. For example at 200mm in the slot 7 the measured voltage without pressure is approximately 5V, whereas the measured voltage with hereby applied pressure of 400mBar is approximately 14V. The sensitivity of the method and the tool 1 can be enhanced with the example of the invention using a pressurizing medium 9 to apply a pressure exerted at the measuring tips 2, 3, 4.

Fig. 5 shows curves calculated by the processor 30 on basis of measurements in the slot 7 according to an example of the invention. The length s of the slot 7 is plotted at the horizontal axis in meter m, from zero to four meters. The voltage and the voltage drop is plotted at the vertical axis in volt with the scale at the left. Also, an alpha coefficient is plotted at the vertical axis in kΩ/m with the scale at the right. The alpha coefficient characterizes the electrical contact between the core 8 and the measuring tips 2, 3, 4. The calculation of the alpha coefficient is known in the state of the art. An approximation of the alpha coefficient is calculated with the following equation: α=(-1/x)*ln(U₂/U₁). The exact calculation of the alpha coefficient is: α=(2/x)*(1- √(*U₂*/*U*_{*1*)})/(1+ √(*U₂*/*U₁₎*)². With the voltages *U₂* and *U₁* being measured voltages between the measuring spots at the measuring tips 2, 3, 4. The top curve shows the constant resistance R of 10kΩ/m between the measuring spots of the slot 7. The curve starting at the left side at one end of the slot 7 with a calculated value of -13V characterizes the voltages calculated from measurements in the slot 7. The calculated values of this curve are illustrated with circles at the curve. This curve increases to a value of 0V for most length of the slot 7 and further increases to a value of +13V at the second end of the slot 7. It can be identified with the curve that a voltage rise of 13V appears at one end of the slot 7 and another voltage rise of 13V at the other end of the slot 7. The voltage V rises between approximately 0.0m and 0.5m and between 3.3m and 3.7m in the slot 7 creating a steplike curve. The second curve illustrates the alpha coefficient calculated by the processor 30, starts with 5/m, drops to - 10/m, and rises to 5/m again with the shape of the curve of a trough. The calculated values are plotted with triangles at the curve. This curve shows that the first and the last 1.5 arrays have a high alpha coefficient. The measurement values from the tool 1 are transmitted to the processor 30 which concludes and calculates from this data the alpha coefficients and based on this the contamination of the slot 7. This is done with tables stored in the processor 30. From the curves illustrated in Fig. 5 and compared with stored data the processor 30 outputs results that characterize the contamination in the measured slot 7. From Fig. 5 it is derived that contaminations are present at both ends of the slot 7, roughly between zero and 0.7m and between 3.2m and 4m along the slot 7. For example calculated alpha coefficient values higher than zero indicate to the operator that a need for cleaning exists at the corresponding area in the slot 7. Both ends have to be cleaned accordingly, while the bigger part in the middle of the slot 7 with low values of the alpha coefficient is essentially clean and needs no cleaning. The results obtained bring advantages for maintenance. The parts of the slot 7 which need cleaning are determined. Costly cleaning of parts with sufficient functionality which are not contaminated is avoided. Moreover, over-cleaning with the danger of damaging the highly precise fabricated slots 7 is avoided. Subsequent to the measurements and calculations as described the cleaning process can be selectively performed. As described the functional capability of an electric machine is checked by means of the degree of contamination in the slot 7 for housing a conductor bar, as contaminations in the slot 7 impair this functionality.

While the invention has been described in detail with reference to exemplary embodiments thereof, it will be apparent to one skilled in the art that various changes can be made, and equivalents employed, without departing from the scope of the invention. The foregoing description of the preferred embodiments of the invention has been presented for purposes of illustration and description. It is not intended to be exhaustive or to limit the invention to the precise form disclosed, and modifications and variations are possible in light of the above teachings or may be acquired from practice of the invention. The embodiments were chosen and described in order to explain the principles of the invention and its practical application to enable one skilled in the art to utilize the invention in various embodiments as are suited to the particular use contemplated. It is intended that the scope of the invention be defined by the claims appended hereto, and their equivalents.

### REFERENCE NUMBERS

- 1: tool
- 2: measuring tip
- 3: measuring tip
- 4: measuring tip
- 7: slot
- 8: core or magnetic core
- 9: pressurizing medium
- 10: voltage generator
- 11: signal line
- 13: pressure wedge
- 14: radial wedge
- 15: pressure screw
- 16: half body
- 18: sliding rule
- 19: bottom wedge
- 20: voltmeter
- 21: inflatable device
- 30: processor

## Claims

1. A tool (1) to measure a contamination in a slot (7) for a conductor bar of an electric machine, comprising a voltage generator (10) to apply a voltage at the slot (7) and a voltmeter (20) to measure a voltage drop along the slot (7), and a processor (30) to calculate the contamination from the voltage drop.

2. The tool (1) according to claim 1, **characterized in** measuring tips (2,4,6) arranged between the slot (7) and a pressurizing medium (9) to exert a pressure to the measuring tips (2,4,6).

3. The tool (1) according to claim 2, **characterized in that** the pressurizing medium (9) is an inflatable tube.

4. The tool (1) according to claim 2, **characterized in that** the pressurizing medium (9) is a pressure screw (15) which engages at least one wedge (13, 14, 19) to exert a pressure to the measuring tips (2,4,6) in a direction perpendicular to the slot (7) via the at least a wedge (13, 14, 19).

5. The tool (1) according to claim 4, **characterized in that** the pressurizing medium (9) contains at least one inflatable device (21) to adjust the position of the pressurizing medium (9) within the slot (7) by inflation.

6. Method to measure a contamination in a slot (7) for a conductor bar of an electric machine with the steps of applying a voltage at the slot (7), measuring a voltage drop along the slot (7), and calculating the contamination in the slot (7) on basis of the measured voltage drop.

7. The method to measure a contamination in a slot (7) for a conductor bar according to claim 6, with the step of arranging a pressurizing medium (9) in the slot (7) and exerting a pressure to the measuring tips (2,4,6) by the pressurizing medium (9).
